# EUROPÄISCHE PATENTSCHRIFT

(11) **EP 1 110 249 B1**
(45) Veröffentlichungstag und Bekanntmachung des Hinweises auf die Patenterteilung: **09.08.2006**
(21) Anmeldenummer: 00945569.2
(22) Anmeldetag: 26.05.2000
(51) Int. Cl.: H01L 41/047, H01L 41/083

(54) **PIEZOAKTOR MIT VERBESSERTEN ELEKTRODENANSCHLÜSSEN**
PIEZOELECTRIC ACTUATOR WITH IMPROVED ELECTRODE CONNECTIONS
ACTIONNEUR PIEZO-ELECTRIQUE A RACCORDEMENTS D'ELECTRODES AMELIORES

(30) Priorität: 19.06.1999 DE 19928189
(43) Veröffentlichungstag der Anmeldung: 27.06.2001
(73) Patentinhaber: ROBERT BOSCH GMBH, 70442 Stuttgart (DE)
(72) Erfinder: HEINZ, Rudolf, D-71272 Renningen (DE)
(86) Internationale Anmeldenummer: PCT/DE2000/001718
(87) Internationale Veröffentlichungsnummer: WO 2000/079607

(56) Entgegenhaltungen:
- EP-A- 0 844 678
- DE-C- 19 715 488
- PATENT ABSTRACTS OF JAPAN vol. 1999, no. 01, 29. Januar 1999 (1999-01-29) & JP 10 284763 A (CHICHIBU ONODA CEMENT CORP), 23. Oktober 1998 (1998-10-23) -& JP 10 284763 A (CHICHIBU ONODA CEMENT CORP) 23. Oktober 1998 (1998-10-23)
- PATENT ABSTRACTS OF JAPAN vol. 011, no. 127 (E-501), 21. April 1987 (1987-04-21) & JP 61 272984 A (NEC CORP), 3. Dezember 1986 (1986-12-03)
- PATENT ABSTRACTS OF JAPAN vol. 008, no. 264 (E-282), 4. Dezember 1984 (1984-12-04) & JP 59 135784 A (NIPPON SOKEN INC), 4. August 1984 (1984-08-04) -& JP 59 135784 A (NIPPON SOKEN INC) 4. August 1984 (1984-08-04)
- PATENT ABSTRACTS OF JAPAN vol. 1997, no. 01, 31. Januar 1997 (1997-01-31) & JP 08 236828 A (NIPPONDENSO CO LTD), 13. September 1996 (1996-09-13) -& JP 08 236828 A (NIPPONDENSO CO LTD) 13. September 1996 (1996-09-13)

## Beschreibung

### Stand der Technik

Die Erfindung betrifft einen Piezoaktor, beispielsweise zur Betätigung eines mechanischen Bauteils wie ein Ventil oder dergleichen, nach den gattungsgemäßen Merkmalen des Hauptanspruchs.

Es ist allgemein bekannt, dass unter Ausnutzung des sogenannten Piezoeffekts ein Piezoelement aus einem Material mit einer geeigneten Kristallstruktur aufgebaut werden kann. Bei Anlage einer äußeren elektrischen Spannung erfolgt eine mechanische Reaktion des Piezoelements, die in Abhängigkeit von der Kristallstruktur und der Anlagebereiche der elektrischen Spannung einen Druck oder Zug in eine vorgebbare Richtung darstellt. Der Aufbau dieses Piezoaktors kann hier in mehreren Schichten erfolgen (Multilayer-Aktoren), wobei die Elektroden, über die die elektrische Spannung aufgebracht wird, jeweils zwischen den Schichten angeordnet werden.

Solche Piezoaktoren, wie sie beispielsweise aus der DE 33 30 538 A1 bekannt sind, können beispielsweise für den Antrieb von Schaltventilen bei Kraftstoffeinspritzsystemen in Kraftfahrzeugen vorgesehen werden. Beim Betrieb des Piezoaktors ist hier insbesondere darauf zu achten, dass durch mechanische Spannungen im Lagenaufbau auch keine störenden Rissbildungen im Bereich der äußeren Anschlusselektroden entstehen. Da die jeweils an einer Seite kontaktierten Innenelektroden kammartig in den Lagenaufbau integriert sind, müssen die in Richtung des Lagenaufbaus aufeinanderfolgenden Elektroden jeweils abwechseln an gegenüberliegen Seiten kontaktiert werden. Bei einer Betätigung des Piezoaktors, d. h. bei Anlage einer Spannung zwischen den im Lagenaufbau gegenüberliegenden Innenelektroden, treten unterschiedliche mechanische Kräfte im Bereich der Innenelektroden sowie im Bereich der Kontaktierungen an den Außenelektroden auf, die zu mechanischen Spannungen und dadurch zu Rissen in den Außenelektroden führen können.

Der eingangs beschriebene Piezoaktor, der beispielsweise zur Betätigung eines mechanischen Bauteils verwendbar sein kann, ist in vorteilhafter Weise dadurch weitergebildet, dass mindestens eine Schicht der jeweiligen Außenelektrode netz- oder gewebeartig auf jeweils einer Seitenfläche verteilt aufgebaut und zumindest punktweise mit den jeweiligen Innenelektroden kontaktiert ist.

### Vorteile der Erfindung

Zwischen den Kontaktierungen liegt hierbei erfindungsgemäss jeweils ein dehnbarer Bereich und die Zuführung der elektrischen Spannung erfolgt über Anschlüsse, die ebenfalls im Bereich der Kontaktfläche oder zwischen den Kontaktierungspunkten dehnbare Bereiche aufweisen. Alternativ oder in Kombination dazu können die Anschlüsse auch an elastischen Falzbereichen liegen.

Ebenso ist eine alternative Ausgestaltung des Gegenstandes der Erfindung möglich, bei der die Anschlüsse für die elektrische Spannung über einen Lötkontakt erfolgen, der an einem Bereich des Lagenaufbaus des Piezoaktors angeordnet ist, der dadurch, dass die Innenelektroden nicht bis an den Rand des Piezoaktors geführt sind, keine aktive Längsdehnung aufweist.

In bekannter Weise ist als eine erste Schicht der Außenelektrode beispielsweise eine Metallfläche auf jeweils einer Seitenfläche angeordnet, die mit den jeweiligen Innenelektroden kontaktiert ist. Die netz- oder gewebeartige Schicht als zweite Außenelektrode ist dann über der ersten Schicht angeordnet, wobei diese zumindest punktweise mit der ersten Schicht kontaktiert ist. Zwischen den Kontaktierungen kommt erfindungsgemäss ein dehnbarer Bereich zu liegen. Die Zuführung der elektrischen Spannung erfolgt dann auch hier über Anschlüsse an der zweiten Außenelektrode, die ebenfalls im Bereich der Kontaktfläche oder zwischen den Kontaktpunkten dehnbare Bereiche aufweisen.

Die netz- oder gewebeartige Außenelektroden dienen zur Vermeidung von Querrissen, die von den Innenelektroden durch Delamination, wie eingangs erwähnt, auftreten können. Die netz- oder gewebeartigen Außenelektroden können dabei in vorteilhafter Weise nur punktuell angelötet sein, damit keine großen Schubspannungen bei der Dehnung des Piezoaktors in den Außenelektroden entstehen, was das Abreißen der Elektroden zur Folge haben kann.

Bei einer anderen Ausführungsform können die Anschlüsse für die elektrische Spannung in vorteilhafter Weise über einen Löt-, Schweiß- oder Crimpkontakt erfolgen, der sich an einem Falzbereich der netz- oder gewebeartigen Außenelektrode befindet. Möglich ist hierbei, dass die Anschlüsse über einen flachen Draht erfolgen, der innen im Falzbereich angeordnet ist.

Weiterhin ist es möglich, dass die Anschlüsse für die elektrische Spannung über einen Draht erfolgen, der linienförmig an dem sich über die ganze Länge des Piezoaktors erstreckenden Falzbereich angeordnet ist oder auch über einen seitlich oder senkrecht gewellten Draht und einen Löt-, Schweiß- oder Crimpkontakt erfolgen, der sich punktweise an der gewebeartigen Außenelektrode befindet.

Ferner können die Anschlüsse für die elektrische Spannung jeweils auch über eine Kammelektrode und einen Löt- oder Schweißkontakt erfolgen, der sich punktweise an den vorzugsweise elastischen Kämmen und der zweiten Außenelektrode befindet.

Diese und weitere Merkmale von bevorzugten Weiterbildungen der Erfindung gehen außer aus den Ansprüchen auch aus der Beschreibung und den Zeichnungen hervor wobei die einzelnen Merkmale jeweils für sich allein oder zu mehreren in Form von Unterkombinationen bei der Ausführungsform der Erfindung und auf anderen Gebieten verwirklicht sein und vorteilhafte sowie für sich schutzfähige Ausführungen darstellen können, für die hier Schutz beansprucht wird.

### Zeichnung

Ausführungsbeispiele des erfindungsgemäßen Piezoaktors werden anhand der Zeichnung erläutert. Es zeigen:
Figur 1 einen Schnitt durch einen Piezoaktor mit einem Mehrschichtaufbau von Lagen aus Piezokeramik und Innenelektroden sowie einer netzartigen Außenelektrode auf einer ersten flächigen Außenelektrode;
Figur 2 eine Draufsicht auf die netzartige Außenelektrode nach der Figur 1 mit den Anschlüssen für eine elektrische Spannung;
Figur 3 einen Detailschnitt durch den Lagenaufbau im Bereich der elektrischen Anschlüsse;
Figur 4 eine Abwandlung des Beispiels nach der Figur 3 mit auf dem Falzbereich liegenden elektrischen Anschlüssen;
Figur 5 eine Abwandlung des Beispiels nach der Figur 4 mit einem in den Falzbereich gelegten Anschlussdraht;
Figur 6 ein Ausführungsbeispiel bei dem die netzartige Außenelektrode durch Bügellöten mit der ersten Außenelektrode verbunden wird;
Figur 7 ein Ausführungsbeispiel bei dem die netzartige Außenelektrode durch Crimpen mit dem Anschlussdraht verbunden wird;
Figur 8 ein Ausführungsbeispiel bei dem die netzartige Außenelektrode auf der gesamten Länge des Piezoaktors durch Bügellöten oder Crimpen an einem Falzbereich mit dem Anschlussdraht verbunden wird;
Figuren 9, 10 und 11 jeweils Ansichten eines gewellten Anschlussdrahtes für die elektrischen Anschlüsse und
Figuren 12 und 13 zwei Ansichten eines kammartigen elektrischen Anschlussdrahtes.

### Beschreibung der Ausführungsbeispiele

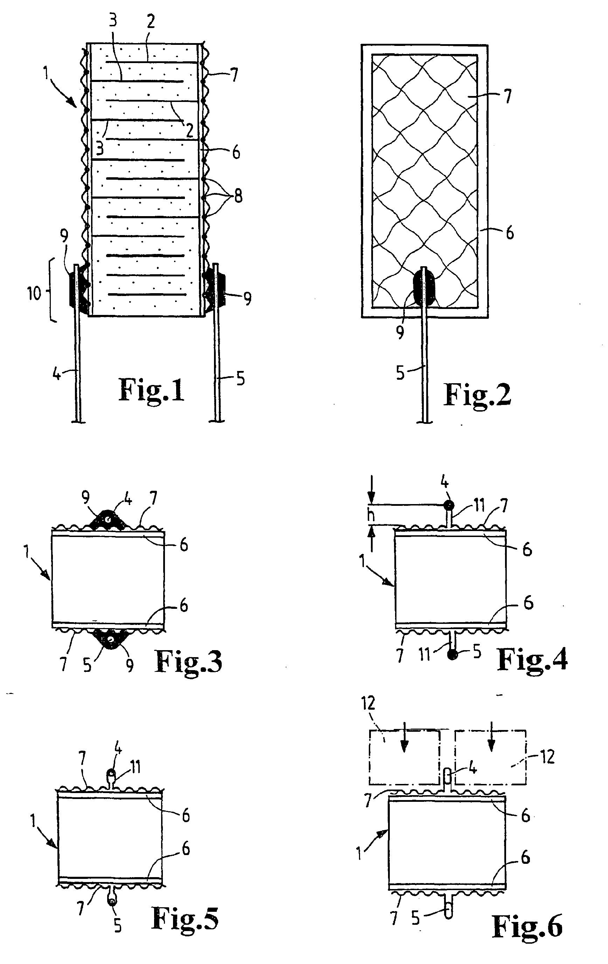

In Figur 1 ist ein Piezoaktor 1 gezeigt, der in an sich bekannter Weise aus Piezofolien eines Keramikmaterials mit einer geeigneten Kristallstruktur aufgebaut ist, so dass unter Ausnutzung des sogenannten Piezoeffekts bei Anlage einer äußeren elektrischen Spannung an Innenelektroden 2 und 3 über elektrische Anschlüsse 4 und 5 eine mechanische Reaktion des Piezoaktors 1 erfolgt. Aus Figur 2 ist eine Seitenansicht dieser Anordnung und aus Figur 3 ist ein Schnitt im Bereich der Anschlussdrähte 4 und 5 zu entnehmen.

Mit den Innenelektroden 2 und 3 steht eine erste flächige Außenelektrode 6 in Kontakt, die wiederum mit einer zweiten netzartigen Außenelektrode 7 über Punktkontakte 8, beispielsweise durch Löten oder Schweißen, kontaktiert ist. Die erste Außenelektrode 6 kann eine dünne, z.B. einige µm dicke, Schicht aus Ni, Ni+Cu oder Ni+PbSn sein, die direkt auf der Oberfläche des Piezoaktors 1 haftet. Die Anschlussdrähte 4 und 5 sind mit der netzartigen Außenelektrode 7 an einer Kontaktstelle 9 durch Löten oder Schweißen verbunden. Zur Vermeidung des Abreißens der Lötstelle 9 ist im Piezoaktor 1 nach der Figur 1 eine passiver Fußbereich 10 vorgesehen, bei dem die Innenelektroden 2 und 3 nicht bis zu den Außenelektroden 6 und 7 geführt sind und daher keine mechanische Reaktionen aufgrund des Piezoeffekts auftreten. Die in der Beschreibungseinleitung erwähnten Nachteile durch eine ev. Rissbildung sind dadurch in dem Fußbereich 10 vermieden.

Aus Figur 4 ist ein Ausführungsbeispiel zu entnehmen, bei dem ein Bereich der Außenelektrode 7 zur Befestigung des Anschlussdrahtes 4 oder 5 gefalzt ist und dadurch eine Versteifung an der Lötstelle 9 und damit eine Rissbildung vermieden ist. Mann erhält somit über eine Höhe h einen elastischen Falzbereich 11 in dem der Piezoaktor 1 sich dehnen kann ohne dass der versteifende Anschlussdraht 4 oder 5 diese behindert. Vorteilhaft wäre hier insbesondere das Anschweißen des Anschlussdrahtes 4 oder 5, da somit kein Lot über die Strecke h fließen kann, was andernfalls zu einer Versteifung führen könnte. Ein passiver Fußbereich, wie anhand der Figuren 1 bis 3 vorgesehen, kann hier entfallen.

Bei der in Figur 5 gezeigten Abwandlung der Ausführungsform nach der Figur 4 ist der jeweilige Anschlussdraht 4 oder 5 im Inneren des Falzbereichs 11 angeschweißt.

Nach dem Ausführungsbeispiel aus Figur 6 ist ein flacher, innen angeschweißter Anschlussdraht 4 oder 5 vorgesehen, der es durch seine geringe Breite ermöglicht, mit Heizplatten 12 ein Bügellöten der netzartigen Außenelektrode auf der ersten Außenelektrode durchzuführen.

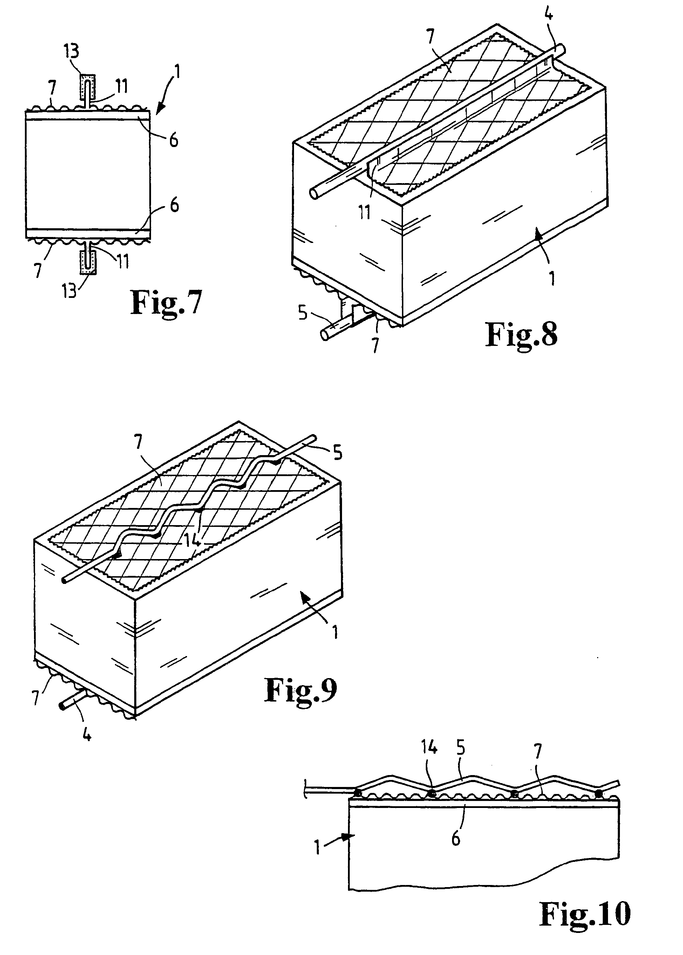

Aus Figur 7 ist eine Ausführungsform zu entnehmen, bei der der jeweilige Anschlussdraht 4 oder 5 eine über den Falzbereich 11 gelegte gecrimpte Schiene 13 ist.

Figur 8 zeigt eine Abwandlung der Befestigung der Anschlussdrähte 4 und 5, bei der ein durchgehender Draht über die gesamte Länge des Piezoaktors 1 geführt ist. Bei einem lokalen Löten oder Schweißen an der Falzstelle 11 ist das Auftreten von Ermüdungsrissen zwischen den Drähten 4 oder 5 und der jeweiligen Außenelektrode 7 auch hier vermindert.

Beim Ausführungsbeispiel nach Figur 9 und Figur 10 sind die Anschlussdrähte 4 und 5 gewellt, so dass hierdurch eine Dehnbehinderung der Außenelektrode 7 verringert ist. Die Drähte 4 und 5 werden in Längsrichtung des Piezoaktors 1 an mehreren, kleinen Stellen 14 angeschweißt oder angelötet. Die Drähte 4 und 5 sind nach der Figur 9 und 10 senkrecht zur Ebene der Außenelektrode 7 gewellt, so dass hier auch das anhand der Figur 6 erwähnte Bügellöten zur Anlötung der netzartigen Außenelektrode 7 an den Piezoaktor 1 bzw. an die erste flächige Außenelektrode 6 ohne große Behinderung möglich ist. Der vorher an die Außenelektrode 7 angeschweißte Draht 4 oder 5 kann als Halterung und zur Zentrierung beim Bügellöten herangezogen werden.

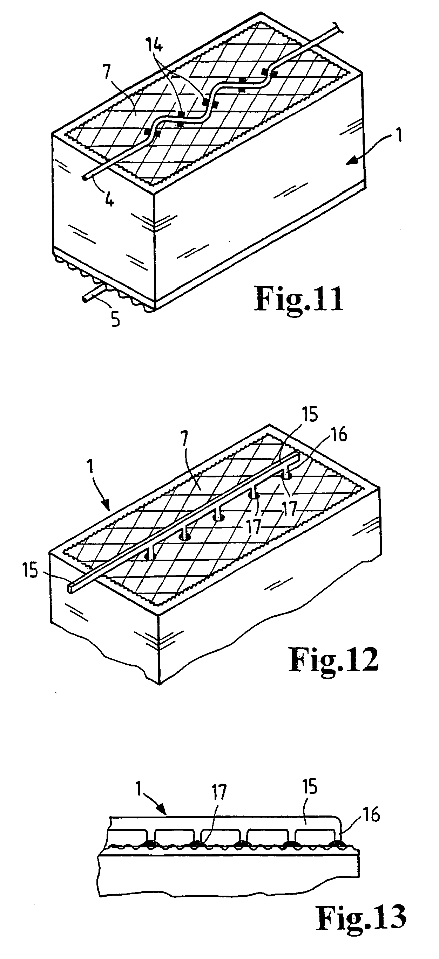

Einen flach auf die netzartige Außenelektrode 7 aufgelöteten oder aufgeschweißten gewellten Anschlussdraht 4 oder 5 zeigt Figur 11. Hier ist auch eine punktweise Kontaktierung an Stellen 14 vorgenommen, wodurch die Dehnfähigkeit der Außenelektrode 7 nicht behindert wird. Das Bügellöten der Außenelektrode kann auch hier durchgeführt werden, am einfachsten wenn der jeweilige Anschlussdraht 4 oder 5 erst danach aufgebracht wird.

Ein weiteres Ausführungsbeispiel zeigt Figur 12 und 13, bei dem jeweils eine Sonderform eines Anschlussdrahtes 15 angebracht wird, bei dem elastische Füße 16 vorhanden sind, die sich kammartig zu Kontaktstellen 17 erstrecken, an denen sie an die jeweilige Außenelektrode 7 angelötet oder angeschweißt werden.

## Patentansprüche

1. Piezoaktor, mit
- einem Mehrschichtaufbau von Piezolagen und dazwischen angeordneten Innenelektroden (2,3),
- einer wechselseitigen seitlichen Kontaktierung der Innenelektroden (2,3) über Außenelektroden (6,7), über die eine elektrische Spannung zuführbar ist, wobei
- eine Außenelektrode (7) netz- oder gewebeartig auf jeweils einer Seitenfläche verteilt aufgebracht ist und zumindest punktweise mit den jeweiligen Innenelektroden (2,3) kontaktiert ist und
- als eine erste Außenelektrode (6) eine leitende Fläche auf jeweils einer Seitenfläche angebracht ist, die mit den jeweiligen Innenelektroden (2,3) kontaktiert ist und die zweite netz- oder gewebeartige Außenelektrode (7) auf der ersten (6) angeordnet ist, wobei die zweite Außenelektrode (7) zumindest punktweise mit der ersten (6) kontaktiert ist und wobei zwischen den Kontaktierungen (8;14;17) der dehnbare Bereich zu liegen kommt,
**dadurch gekennzeichnet, dass**
zwischen den Kontaktierungen ein dehnbarer Bereich zu liegen kommt,
- die Zuführung der elektrischen Spannung über Anschlüsse (4,5;13;15) erfolgt, die ebenfalls zwischen den Bereichen der Kontaktfläche oder -punkte (8;14;17) dehnbare Bereiche aufweisen
und/oder
- die an elastischen Falzbereichen (11) liegen
oder
- die Anschlüsse (4,5) für die elektrische Spannung über einen Lötkontakt (9) erfolgen, der an einem Bereich (10) des Lagenaufbaus des Piezoaktors (1) angeordnet ist, der **dadurch**, dass die Innenelektrode (2,3) nicht bis an den Rand des Piezoaktors (1) geführt sind, nahezu keine Längsdehnung aufweist.

2. Piezoaktor nach Anspruch 1, **dadurch gekennzeichnet, dass**
- die Anschlüsse (4,5;13) für die elektrische Spannung über einen Löt-, Schweiß- oder Crimpkontakt erfolgen, der sich an dem Falzbereich (11) der zweiten Außenelektrode (7) befindet.

3. Piezoaktor nach Anspruch 2, **dadurch gekennzeichnet, dass**
- die Anschlüsse für die elektrische Spannung über einen flachen Draht (4,5) erfolgen, der innen im Falzbereich (11) angeordnet ist.

4. Piezoaktor nach Anspruch 2 oder 3, **dadurch gekennzeichnet, dass**
- die Anschlüsse für die elektrische Spannung über einen Draht (4,5) erfolgen, der sich über einen, über die ganze Länge des Piezoaktors (1) erstreckenden Falzbereich (11) erstreckt.

5. Piezoaktor nach Anspruch 1, **dadurch gekennzeichnet, dass**
- die Anschlüsse für die elektrische Spannung jeweils über einen seitlich oder senkrecht gewellten Draht (4,5) und einen Löt-, Schweiß- oder Crimpkontakt (14) erfolgen, der punktweise an der zweiten Außenelektrode (7) angeordnet ist.

6. Piezoaktor nach Anspruch 1, **dadurch gekennzeichnet, dass**
- die Anschlüsse für die elektrische Spannung jeweils über einen kammartigen Draht (15) und einen Löt- oder Schweißkontakt (17) erfolgen, der sich jeweils an den elastischen Kämmen (16) und der zweiten Außenelektrode (7) befindet.

## Claims

1. Piezoelectric actuator, with
- a multilayered structure of piezoelectric layers and internal electrodes (2, 3) arranged between them,
- an alternating lateral contacting of the internal electrodes (2, 3) by means of external electrodes (6, 7), via which an electrical voltage can be supplied,
- an external electrode (7) being mounted on a respective side surface such that it is distributed in a net-like or woven cloth-like fashion and being contacted at least at points by the respective internal electrodes (2, 3), and
- a conducting surface being mounted as a first external electrode (6) on a respective side surface which is contacted by the respective internal electrodes (2, 3) and the second net-like or woven cloth-like external electrode (7) being arranged on the first one (6), the second external electrode (7) being contacted by the first one (6) at least at points, and the expandable region coming to lie between the contacts (8; 14; 17),
**characterized in that**
- an expandable region comes to lie between the contacts,
- the electrical voltage is supplied by means of connections (4, 5; 13; 15), which likewise have expandable regions between the regions of the contact surface or contact points (8; 14; 17)
and/or
- which lie on elastic folded regions (11)
or
- the connections (4, 5) for the electrical voltage are produced by means of a soldered contact (9), which is arranged on a region (10) of the layer structure of the piezoelectric actuator (1) which experiences virtually no longitudinal expansion because the internal electrodes (2, 3) do not extend to the edge of the piezoelectric actuator (1).

2. Piezoelectric actuator according to Claim 1,
**characterized in that**
- the connections (4, 5; 13) for the electrical voltage are produced by means of a soldered, welded, or crimped contact, which is located on the folded region (11) of the second external electrode (7).

3. Piezoelectric actuator according to Claim 2,
**characterized in that**
- the connections for the electrical voltage are produced by means of a flat wire (4, 5) which is arranged inside the folded region (11).

4. Piezoelectric actuator according to Claim 2 or 3,
**characterized in that**
- the connections for the electrical voltage are produced by means of a wire (4, 5), which extends over a folded region (11) extending the entire length of the piezoelectric actuator (1).

5. Piezoelectric actuator according to Claim 1,
**characterized in that**
- the connections for the electrical voltage are each produced by means of a laterally or perpendicularly wavy wire (4, 5) and a soldered, welded, or crimped contact (14), which is arranged at points on the second external electrode (7).

6. Piezoelectric actuator according to Claim 1,
**characterized in that**
- the connections for the electrical voltage are respectively produced by means of a comb-like wire (15) and a soldered or welded contact (17) which is respectively located on the elastic combs (16) and the second external electrode (7).

## Revendications

1. Actionneur piézoélectrique, avec
- une structure multicouche de couches piézoélectriques et d'électrodes internes (2, 3) disposées entre celles-ci,
- un point de contact latéral alterné des électrodes internes (2, 3) par des électrodes externes (6, 7), pouvant amener une tension électrique,
- une électrode externe (7) est placée en forme de réseau ou de tissu réparti respectivement sur une face latérale et est raccordée au moins ponctuellement avec les électrodes internes respectives (2, 3), et
- comme première électrode externe (6) une face conductrice appliquée chaque fois sur une face latérale et raccordée aux électrodes internes respectives (2, 3), alors que la deuxième électrode externe (7) en forme de réseau ou de tissu est disposée sur la première (6), la deuxième électrode externe (7) étant raccordée au moins ponctuellement avec la première (6) et la région dilatable venant se placer entre les points de contact (8 ; 14 ; 17),
**caractérisé en ce que**
- une région dilatable vient se placer entre les points de contact,
- l'application de la tension électrique est réalisée par des raccordements (4, 5; 13; 15) qui présentent également des régions dilatables entre les régions de la face de contact ou des points de contact (8 ; 14 ; 17),
et/ ou
- qui se trouvent sur des zones de plis élastiques (11),
ou
- les raccordements (4, 5) pour la tension électrique sont réalisés par un contact brasé (9) sur une région (10) de la structure multicouches de l'actionneur piézoélectrique (1), qui ne présente quasi aucune dilatation longitudinale du fait que les électrodes internes (2, 3) ne sont pas menées jusqu'au bord de l'actionneur piézoélectrique (1).

2. Actionneur piézoélectrique selon la revendication 1,
**caractérisé en ce que**
les raccordements (4, 5 ; 13) pour la tension électrique sont réalisés par un contact brasé, soudé ou serti, qui se trouve sur la zone pliée (11) de la deuxième électrode externe (7).

3. Actionneur piézoélectrique selon la revendication 2,
**caractérisé en ce que**
les raccordements pour la tension électrique sont réalisés par un fil plat (4, 5), disposé à l'intérieur de la zone pliée (11).

4. Actionneur piézoélectrique selon la revendication 2 ou 3,
**caractérisé en ce que**
les raccordements pour la tension électrique sont réalisés par un fil (4, 5), qui s'étend sur une zone pliée (11) correspondant à la totalité de la longueur de l'actionneur piézoélectrique (1).

5. Actionneur piézoélectrique selon la revendication 1,
**caractérisé en ce que**
les raccordements pour la tension électrique sont réalisés chaque fois par un fil ondulé latéralement ou perpendiculairement (4, 5) et un contact brasé, soudé ou serti (14), disposé ponctuellement sur la deuxième électrode externe (7).

6. Actionneur piézoélectrique selon la revendication 1,
**caractérisé en ce que**
les raccordements pour la tension électrique sont réalisés chaque fois par un fil à dents de peigne (15) et un contact brasé ou soudé (17), qui se trouve chaque fois sur les dents élastiques (16) et sur la deuxième électrode externe (7).
